# EUROPEAN PATENT APPLICATION

(11) **EP 1 950 814 A1**
(43) Date of publication of application: **30.07.2008**
(21) Application number: 07001465.9
(22) Date of filing: 24.01.2007
(51) Int. Cl.: H01L 33/00

(54) **LED with light diverging arrangement**

(71) Applicant: Stekelenburg, Albert, Taipei (TW)
(72) Inventor: Stekelenburg, Albert, Taipei (TW)
(74) Representative: Köhler, Walter

(57) **Abstract**

A LED includes a first substrate (10) having a recess, a second substrate (40) having a polarity opposing that of the first substrate (10), a LED chip (20) die-bonded on the recess, a bonding wire (30) interconnecting the LED chip (20) and the second substrate (40), and a case (50) formed around the first substrate (10), the second substrate (40), the LED chip (20), and the bonding wire (30); The case (50) includes a curve rough surface on a front portion. The curve rough surface is adapted to diverge light emitted by the LED chip (20) such that light can be transmitted toward a wider area. Either ridges or grooves are formed on the curve rough surface. The curve rough surface is formed by either injection molding in the packaging process of the case (50) or adhering after the injection molding process.

## Description

### BACKGROUND OF THE INVENTION

### 1. Field of Invention

The invention relates to LED (light-emitting diode) packaging and more particularly to such a LED having ridges or grooves formed on a front curve surface of a case thereof for diverging light such that light can be transmitted toward a wider area.

### 2. Description of Related Art

LEDs, having improved light emission efficiency due to significant progress of semiconductor industry and material science in recent several decades, have been widely employed as lighting equipment, car lights, flashlights or the like. Moreover, LEDs have advantages of low power consumption, low heat generation, low operating voltage, and no toxic material generation in operation. Thus, there is a trend of replacing the typical light bulbs with LEDs.

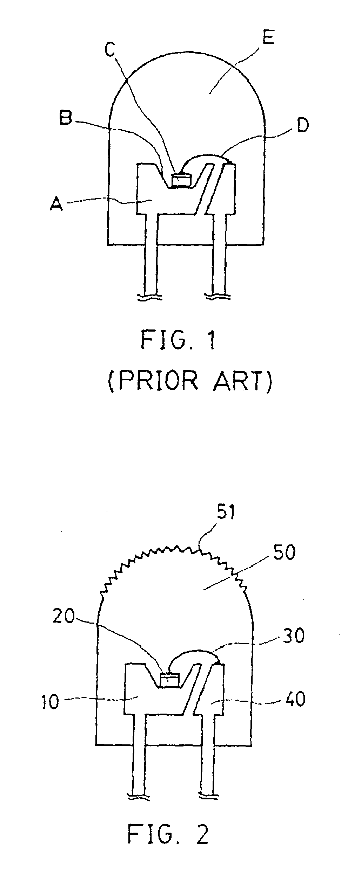

A conventional LED is schematically shown in a sectional view in FIG. 1 The LED comprises a first substrate (e.g., n-type substrate) A having a recess B formed on a top, a LED chip C die-bonded on the recess B, a bonding wire D interconnecting the LED chip C and a second substrate (e.g., p-type substrate), and a case E formed by filling liquid crystal polymer around the above components in a mold and curing thereafter.

The liquid crystal polymer is selected from a group consisting of epoxy resin, acrylic resin, and silicon rubber. For increasing light transmitting toward the curve portion (i.e., front portion) of the LED (i.e., concentrating light on a direction aligned with the front portion of the LED), it is typical of making portions of the case E other than the front portion thereof opaque. Further, it is typical of forming a curve surface (as shown) on the front portion of the LED so as to diverge light. Thus, continuing improvements in the exploitation of LED with light diverging arrangement are constantly being sought.

### SUMMARY OF THE INVENTION

It is therefore one object of the invention to provide a LED having a rough curve portion formed on a front surface of a case thereof for diverging light such that light can be transmitted toward a wider area.

In one aspect of the invention either ridges or grooves are formed on the rough curve portion.

In another aspect of the invention the rough curve portion is formed on the case surface by either injection molding in the packaging process of the case or adhering after the injection molding process.

In a further aspect of the invention the rough curve portion is formed on the case surface by forming a smooth curve surface on the case first and by rubbing the rough curve portion by means of sandpapers thereafter.

The above and other objects, features and advantages of the invention will become apparent from the following detailed description taken with the accompanying drawings.

### BRIEF DESCRIPTION OF THE DRAWINGS

FIG. 1 is a schematic sectional view of a conventional LED;
FIG. 2 is a schematic sectional view of a first preferred embodiment of LED according to the invention;
FIG. 3 is a schematic sectional view of a second preferred embodiment of LED according to the invention; and
FIG. 4 is a schematic sectional view of a third preferred embodiment of LED according to the invention.

### DETAILED DESCRIPTION OF THE INVENTION

Referring to FIG. 2, a LED in accordance with a first preferred embodiment of the invention is shown The LED comprises a first substrate (e.g., n-type substrate) 10 having a recessed top, a LED chip 20 die-bonded on the top of the first substrate 10, a bonding wire 30 interconnecting the LED chip 20 and a second substrate (e.g., p-type substrate) 40, and a case 50 formed by filling liquid crystal polymer in a mold around the above components and curing thereafter.

The subject matter of the invention is the case 50 as detailed below. As to other components, they are well known devices and a detailed description thereof is therefore deemed unnecessary.

As shown, the case 50 has a curve surface on a front portion. Further, a plurality of ridges 51 are formed on the curve surface of the case 50 by either injection molding in the packaging process of the case 50 or adhering after the injection molding process.

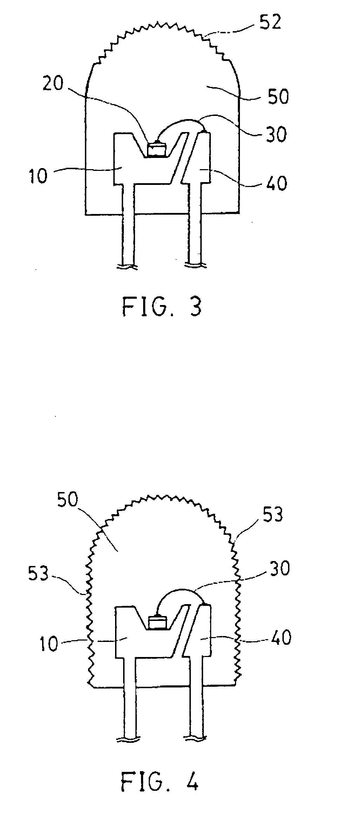

Referring to FIG. 3, a LED in accordance with a second preferred embodiment of the invention is shown. The characteristic of the second preferred embodiment is detailed below. A plurality of grooves 52 are formed on the curve surface of the case 50 by either injection molding in the packaging process of the case 50 or cutting after the injection molding process.

The forming of the ridges 51 or the grooves 52 aims at diverging light emitted by the LED chip 20 such that light can be transmitted toward a wider area.

Alternatively, it is possible of first forming a smooth curve surface on the case 50 and then rubbing the smooth curve surface by means of sandpapers so as to form a rough curve portion. The purpose of diverging light can also be achieved.

Referring to FIG. 4, a LED in accordance with a third preferred embodiment of the invention is shown. The characteristic of the third preferred embodiment is detailed below. A plurality of troughs 53 are formed on the whole surface of the case 50 by either injection molding in the packaging process of the case 50 or cutting after the injection molding process. The third embodiment aims at further diverging light.

While the invention herein disclosed has been described by means of specific embodiments, numerous modifications and variations could be made thereto by those skilled in the art without departing from the scope and spirit of the invention set forth in the claims.

## Claims

1. A LED comprising a first substrate (10) having a recess, a second substrate (40) having a polarity opposing that of the first substrate (10), a LED chip (20) die-bonded on the recess, a bonding wire (30) interconnecting the LED chip (20) and the second substrate (40), and a case (50) formed around the first substrate (10), the second substrate (40), the LED chip (20), and the bonding wire (30), wherein the case (50) includes a curve rough surface on a front portion.

2. The LED of claim 1, further comprising a plurality of ridges formed on the curve rough surface.

3. The LED of claim 1, further comprising a plurality of grooves formed on the curve rough surface.

4. The LED of claim 1, wherein the curve rough surface is formed by grinding.

5. The LED of claim 1, wherein the curve rough surface is formed by adhering.
